# EUROPEAN PATENT APPLICATION

(11) **EP 3 252 816 A1**
(43) Date of publication of application: **06.12.2017**
(21) Application number: 17173995.6
(22) Date of filing: 01.06.2017
(51) Int. Cl.: H01L 27/08, G11C 11/39, H01L 27/102

(54) **THYRISTOR MEMORY CELL WITH GATE IN TRENCH ADJACENT THE THYRISTOR**

(30) Priority: 03.06.2016 US 201662345203 P; 29.06.2016 US 201615197640
(71) Applicant: Kilopass Technology, Inc., San Jose, California 95134 (US)
(72) Inventor: Luan, Harry, Saratoga, CA 95070 (US); Bateman, Bruce L., Fremont, CA 94539 (US); Axelrad, Valery, Woodside, CA 94062 (US); Cheng, Charlie, Los Altos, CA 94024 (US)
(74) Representative: Conroy, John

(57) **Abstract**

A volatile memory array using vertical thyristors with gates, NMOS or PMOS, in trenches adjacent the thyristors is disclosed together with methods of fabricating the array.

## Description

### Cross-Reference to Related Applications

This patent application claims the benefit of U.S. Patent Application No. 15/197,640, filed June 29, 2016 and U.S. Provisional Patent Application No. 62/345,203, filed June 3, 2016, which are incorporated by reference along with all other references cited in this application.

### Background of the Invention

This invention is related to integrated circuit devices and in particular to volatile random access memories, such as dynamic random access memories (DRAMs).

A DRAM is a type of random-access memory that stores one bit of data in a capacitor coupled to a transistor within the integrated circuit. Lithographic scaling and process enhancements usually quadruple number of bits of storage in a DRAM in about every three years. However, the individual memory cells have become so small that maintaining the capacitance of each cell, as well as, reducing charge leakage may significantly inhibit continual size reductions.

What is needed is a DRAM memory cell that is smaller than a conventional one-transistor one-capacitor cell, that is readily scalable below 20nm design rules, that is compatible with standard bulk silicon processing, and that consumes lower power, both statically and dynamically.

### Brief Summary of the Invention

This invention provides a volatile memory array suitable for implementation of dynamic random access memories in which thyristors are formed in bulk silicon substrate and isolated from each other by a shallow trench of insulating material in one direction and a deeper trench of insulating material in a perpendicular direction. The thyristors may include vertical thyristors, such as PNPN or NPNP. The array of memory cells is arranged in a cross-point grid and interconnected by metal conductors and buried heavily doped layers.

In one embodiment the memory array includes row and column lines, and each vertical PNPN thyristor has an anode connected to a row line and a cathode coupled to a column line.

The substrate is preferably P-conductivity type with an N-conductivity type buried layer extending in a first direction to provide a column line and cathodes for the thyristors coupled to that column line. Alternating P-conductivity type and N-conductivity type layers on the buried layer provide the bases of the thyristor, with an upper P-conductivity type layer providing the anodes of the thyristors.

A conductive layer coupled to the anodes of the thyristor extending in a second direction orthogonal to the first direction provides a row line. As desired, gates may be formed in the insulating material to provide NMOS and PMOS transistors for improving switching speed.

In an embodiment, a method of making the array of PNPN vertical thyristors includes introducing N-conductivity type dopant into a P-conductivity type semiconductor substrate, thus providing a buried layer to form the column lines and cathodes for the vertical thyristors.

A P-conductivity type epitaxial layer is then formed over the buried layer. Etching through a mask removes the epitaxial layer and the buried layer to expose portions of the substrate to form parallel deep trenches that are filled with insulating material such as silicon dioxide.

The epitaxial layer is etched again to form parallel shallow trenches that are perpendicular to the deep trenches. After filing the shallow trenches with insulating material the bases and anodes of the thyristor are doped and desired electrical contacts and connectors are formed.

A method of operating the memory array to program a selected thyristor 'on' includes steps of applying a positive potential to the row line to which the selected thyristor is connected and applying a lower potential to the column line to which the selected thyristor is connected a lower potential where the difference between the positive potential and the lower potential is greater than that required to turn on the thyristor. All of the non-selected lines have potentials applied to them insufficient to change the state of other thyristors. To turn the selected thyristor off, a low potential is applied to the row line and a positive potential is applied to the column line sufficient to turn it off. All of the non-selected lines have potentials applied to them insufficient to change the state of other thyristors.

The selected thyristor is read a positive potential to the row line and a lower potential to the column line. The difference between the positive potential and the lower potential is sufficient to pull the column line to a higher potential if the selected thyristor was programmed on, but insufficient to cause the thyristor to pull the column line to a higher potential if the selected thyristor was programmed off.

Potentials applied to the non-selected row and column lines are insufficient to change their data. Maintaining potentials on the row and column lines sufficient to keep thyristors that are on turned on, but insufficient to turn on thyristors that are off, retains the stored data in the array.

A technique for reducing current in a row line to be accessed for an operation is provided. The memory cells coupled to a row line are divided into groups and the column lines for performing operations on the memory cells are carried out by applying the necessary potentials for that operation to only one group at a time. All other column lines are maintained at a lower potential. The operation is then performed and the next group selected.

A method for refreshing the memory array consists of dividing the array into sectors and refreshing it on a sector-by-sector basis, e.g. by providing a refresh line to apply current or voltage pulses to the sector by switchably connecting only those row lines in the sector to be refreshed to the refresh line.

Because the on thyristors dissipate power, power consumption in the array can be controlled by using parity bits to more closely balance numbers of on and off thyristor memory cells. For example two parity bits can define four states for a stored word that represent not changing the stored word, inverting the first four bits of the stored word, inverting the last four bits of the stored word, and inverting all of the stored word. This approach allows the stored words on average to have approximately the same number of on and off thyristors.

Other objects, features, and advantages of the present invention will become apparent upon consideration of the following detailed description and the accompanying drawings, in which like reference designations represent like features throughout the figures.

### Brief Description of the Drawings

Figure 1 is a layout diagram showing the topology of a 2x2 memory cell array as implemented in an integrated circuit. Figure 1 also shows the locations of cross-sections A-A' and B-B' referred to in subsequent figures.
Figure 2 illustrates an A-A' cross-sectional view of a thyristor memory cell with an NMOS gate in a trench adjacent the thyristor.
Figure 3 is a circuit schematic illustrating a 2x2 memory cell array with the NMOS gate shown in Figure 2.
Figure 4 illustrates an A-A' cross-sectional view of a thyristor memory cell with a PMOS gate in a trench adjacent the thyristor.
Figure 5 is a circuit schematic illustrating a 2x2 memory cell array with the PMOS gate shown in Figure 4.
Figure 6 illustrates an A-A' cross-sectional view (cut along a word line) of a thyristor memory cell with a PMOS gate in a trench adjacent the thyristor.
Figure 7 illustrates doping profile of a thyristor memory cell.
Figure 8 illustrates Vhold_min/max vs. T-273 of a thyristor memory cell with a PMOS gate in a trench adjacent the thyristor.
Figure 9 illustrates A0 vs. T-273 of a thyristor memory cell with a PMOS sidewall gate in a trench adjacent the thyristor.
Figure 10 illustrates operating conditions of a thyristor memory cell with a PMOS sidewall gate in trench adjacent the thyristor.

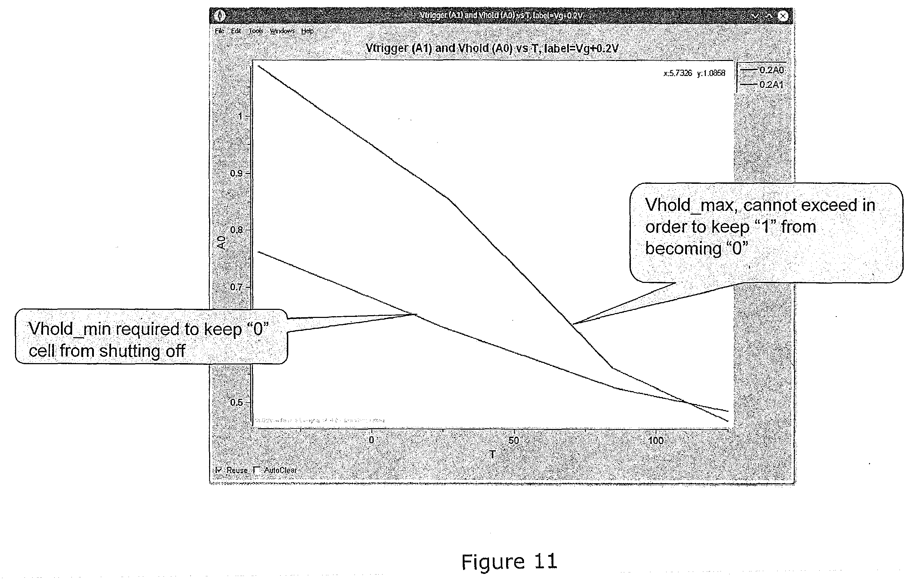

Figure 11 illustrates Vtrigger (A1) and Vhold (A0) vs. Temperature.

### Detailed Description of the Invention

### 1. An Individual Memory Cell

This invention provides a thyristor-based volatile memory cell, methods of manufacturing the cell, and methods of operating an array of such cells. The memory cell has particular utility for use in dynamic random access memory (DRAM) integrated circuit, as well as circuits in which DRAM memories are embedded.

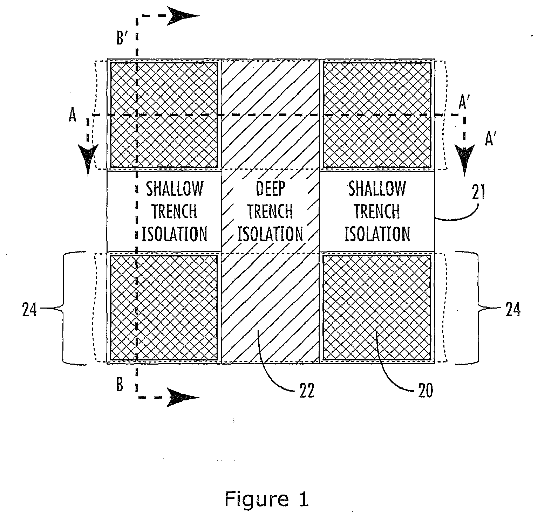

Figure 1 is a layout diagram showing the topology of a 2x2 memory cell array as implemented in an integrated circuit. Figure 1 also shows the locations of cross-sections A-A' and B-B' referred to in subsequent figures.

In an embodiment, the 2x2 memory cell array includes four vertical thyristors, such as PNPN, with anodes 20 at the corners of the layout. A deep silicon dioxide trench 22 isolates the left thyristors from the right thyristors while a shallow trench 21 isolates the upper thyristors from the lower thyristors.

A conductive line 24 provides a row line for the memory array, and is coupled to the anodes of the thyristors. A similar row line (not shown) extends across the anodes of the thyristors in the row above row line 24.

### 2. The Fabrication Process

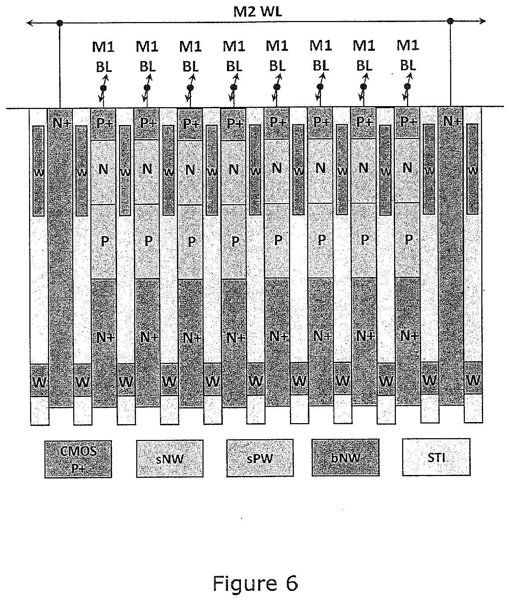

Various embodiments of a process for fabricating a structure shown in an A-A' crosssection view in Figure 6 are described next. First, P-conductivity type silicon substrate are doped with an N-conductivity type dopant, for example, arsenic, to a concentration that ranges from 1E19 to 5E20. The semiconductor substrate layer may include single crystalline semiconductor materials such as silicon or silicon-germanium alloy. The N-conductivity type dopant is introduced by well known semiconductor fabrication techniques, for example, ion implantation, and extends into the substrate to a depth of 200nm~500nm. The entire cell array region is open to this buried N-type doping. Next, an epitaxial silicon layer with a thickness between about 300 nm and 500 nm is formed on top of the underlying structure, also using well-known semiconductor fabrication process technology. The epitaxial layer may be either intrinsic, or in-situ, doped to a P-conductivity type.

Next, a thin silicon dioxide (pad) layer is grown or deposited across an upper surface of the semiconductor structure. A silicon nitride layer is formed over the pad oxide layer using well-known process technology. Using a mask (not shown), openings are etched through the silicon nitride layer and the pad oxide layer to expose an upper surface of the epitaxial layer where deep trenches are to be formed. Using the patterned pads as a hard mask, with or without photoresist removal, a reactive ion etch (RIE) step is then performed to etch the deep trenches that extend through the memory cell area, e.g. as shown in the top view of Figure 1. These deep trenches extend down through the overlying layers to the substrate. Notice that the deep trenches are parallel to each other. The deep trenches are filled with insulating material such as silicon dioxide. This is achieved by first growing a thin liner-oxide on the exposed silicon surface of the sidewalls and bottoms of the trenches. Then using, for example, high-density plasma (HDP) enhanced chemical vapor deposition (CVD), the trenches are filled with silicon dioxide to an appropriate thickness, typically extending above the upper surface of the structure. Next, well-known chemical mechanical polishing (CMP) with high-selectivity slurry is used to planarize the surface and remove the excess trench oxide down to the pad nitride. Then, another masking step is performed and shallow trenches are etched. Note that the depth of the shallower trenches extends to the N-conductivity type epitaxial layer, and not down to the P-type substrate.

Next, the shallow trench is oxidized and then filled with silicon dioxide, in the same manner as described previously. After the trench is filled with silicon dioxide and planarized by CMP, the upper layers of silicon dioxide and silicon nitride are etched away, again using conventional wet, or dry, etching.

Ion implantation steps are used to introduce P-conductivity type and N-conductivity type impurities into the upper surface of the semiconductor creating a PNPN thyristor structure. The N-conductivity type impurity may be arsenic, while the P-conductivity type impurity may be boron, e.g. boron difluoride. Next, a refractory metal, such as titanium, cobalt, or nickel, is deposited on to the upper surface. A rapid-thermal anneal (RTP) is then performed to create a conductive metal silicide in semiconductor regions to provide an ohmic contact to the anode of the thyristor. The un-reacted metal is then removed by a wet etch. The buried N-type region provides the cathode connection.

Conducting lines provide the row lines connecting the anodes of the thyristors of a row together. These conductors may be metal, metal silicide, or doped polysilicon that are formed using well-known semiconductor fabrication techniques.

An alternative embodiment for the anode structure may be formed. A raised source/drain technology may be used to form the anode by selective epitaxial growth of silicon on the upper surface of the structure. This P-type region may be doped in-situ or using a masking and implantation step. As per the previous embodiment, a refractory metal and an annealing step may be used to form the anode electrode. The raised source/drain technology is compatible with a shallower trench, yet still enabling additional space for the N- and P- regions.

An alternative embodiment for manufacture of a vertical thyristor may be used. The previously described method for making the vertical thyristor may result in an implanted P-type base and N-type base regions with peak concentration and thickness limitations resulting from higher energy implant ion scattering and channeling. An alternative process may result in other base doping profiles while maintaining a planar silicon surface.

First, a buried layer N-type implant is performed. Then, epitaxial silicon of a desired thickness, e.g. 80nm - 130nm, is grown across the upper surface. Next, the peripheral region of the integrated circuit is masked with photoresist, or other material. Then, the P-type base region is implanted with appropriate dopant. The masking material is then removed from the wafer and then another epitaxial layer of desired thickness, e.g. 120nm - 200nm, is grown across the upper surface of the wafer, and doped N-type to form the N-type base region. Finally, the alternative process returns to formation of the trench isolation regions as described previously.

### 3. Operation of a Memory Cell Array

An array of memory cells may include the thyristors described above. Various methods are available to operate a memory array of arbitrary size to read, write, and refresh the memory array as appropriate. This invention is not restricted to any particular number of anode and cathode access lines or memory cells. In an exemplary memory array, individual retained, memory cells are each connected to an anode line and a cathode line.

Individual thyristors in an array may, over a period of time, gradually lose their stored data due to leakage currents. While this leakage is substantially less than occurs in a conventional one-transistor one-capacitor DRAM memory cell, to overcome the leakage current, the array can be placed in a standby state so that the stored data is retained. In this condition the 'off' thyristors are not affected, while the 'on' thyristors are continuously charged to the 'on' state. Because this standby state continuously consumes power, there is a trade-off between maintaining the thyristors in standby versus allowing discharge and periodically refreshing the array. In an embodiment, the entire array is refreshed from 1 to 10 times per second. This is less frequent than a conventional FET based DRAM requires refreshing.

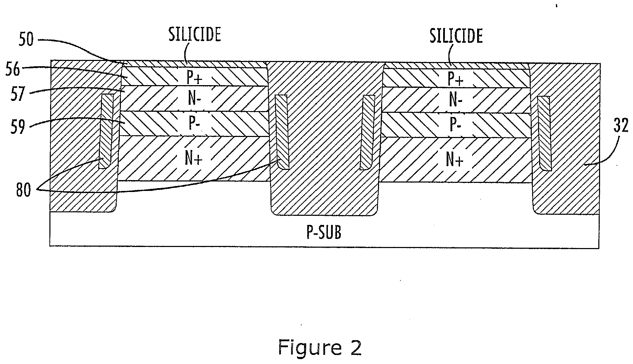

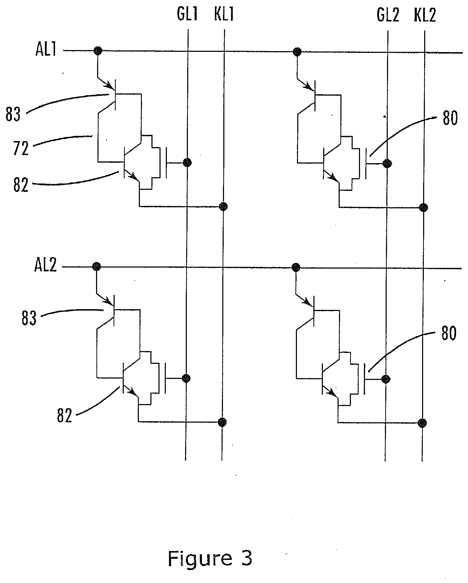

Figure 2 and Figure 3 illustrate other embodiments of the thyristor memory cell of this invention. In an embodiment, NMOS gates 80 may be added to the deep trenches of the structure. The gates may increase write speed and may reduce write voltage. Because addition of the gates increases process complexity, use of the gates is dependent on the particular application expected for the memory array.

The gates 80 may be formed in the deep trenches by first performing the deep silicon etch as described previously. The sidewalls of the trench are then oxidized - thereby forming the gate oxide that isolates the gate electrodes from the doped regions 32, 59, and 57. The trenches are then partially filled with silicon dioxide, e.g. by a chemical vapor deposition process. Then a conformal-doped polycrystalline silicon layer is deposited across the structure. After an anisotropic etching step removes the entire conformal polycrystalline silicon layer except as shown in Figure 2, another trench filling operation is performed to finish filling the trenches. Appropriate planarization steps are then performed, e.g. using chemical mechanical polishing or other techniques. Later in the process an electrical connection is made to couple the gates 80 to control gate lines (GLs).

Figure 3 is a circuit schematic showing an array of thyristor memory cells with the addition of gates 80 as described above. The gates 80, when turned on by gate line GL, short out the NPN transistor 82 connecting the base of the PNP transistor 83 to the cathode line KL. This approach has the advantages described above - reducing the write voltage and allowing faster writes of data.

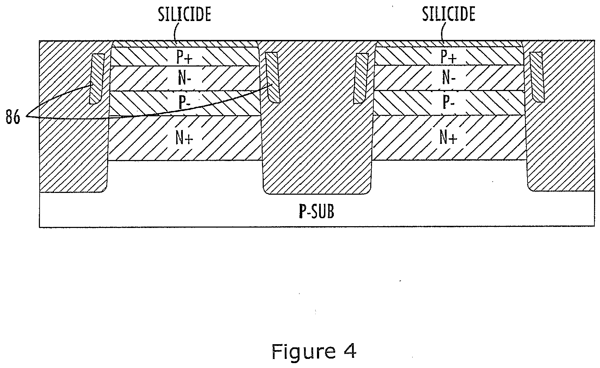

Figure 4 illustrates another embodiment of vertical thyristor cell with sidewall PMOS gates 86 in the deep trenches. These are formed in the same manner as gates 80 described above. The buried gates 86 may be connected at the pick-up regions and coupled to gate lines (GLs). These gates are formed in the same manner as described above. After a deep silicon trenchetching step, the trench gate oxide is formed. The trench is then partially filled with silicon dioxide to a depth above the N-cathode/P-base junction. A conformal conductive gate layer of, e.g. doped polycrystalline silicon is then formed. The gate layer is then anisotropically etched to form a sidewall gate completely covering the N-type base. Finally, the trench is filled with silicon dioxide and then planarized, using well-known technology.

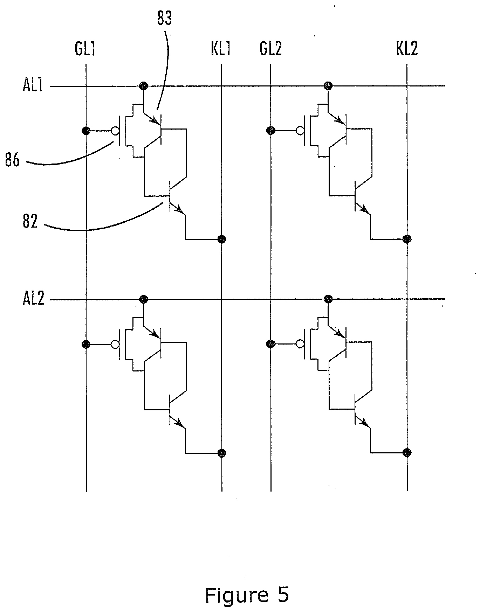

Figure 5 is a circuit schematic of a memory array in which the PMOS gates 86 of Figure 4 are used. The gates 86, when turned on by gate line GL, short out the PNP transistor 83 connecting the base of the NPN transistor 82 to the anode line AL. This approach may have advantages as discussed above for the NMOS gates.

In other embodiments, the gates 80, 86 may be formed partially, or in separate segments, or completely around the thyristor.

In an embodiment, as shown in Figure 2 and Figure 4, two adjacent thyristors separated by a trench may include two separate gates in the trench, one gate each for a nearer thyristor.

In another embodiment (not shown), two adjacent thyristors separated by a trench may include one combined gate that is approximately centered in the trench, the combined gate shared by the two adjacent thyristors.

In an embodiment, a combined gate that is approximately centered in the trench is connected by a long and continuous gate line, parallel to the bit lines, for many contiguous thyristors, the bit lines being in M1 layer.

In another embodiment, a combined gate that is approximately centered in the trench is connected by a short and discontinuous gate line, parallel to the word lines, for some contiguous thyristors, the word lines being in M2 layer.

In an embodiment, two adjacent thyristors separated by a trench may include one combined gate that is off-centered in the trench, the combined gate being used with the nearer thyristor.

In an embodiment, a combined gate that is off-centered in the trench is connected to a gate line that is parallel to the bit lines.

In another embodiment, a combined gate that is off-centered in the trench is connected to a gate line that is parallel to the word lines.

In an embodiment, a gate line in a trench is located adjacent to an upper base of the thyristor.

In an embodiment, a gate line in a trench is located adjacent to a lower base of the thyristor.

In an embodiment, a gate line in a trench is located near a mid-depth of the trench.

In other embodiments, the gates 80 may be formed from other conductive material, such as metal, or silicides, or combinations of different materials.

In an embodiment, the gates 80, 86 may have a thickness of about 30-50 Angstroms.

In an embodiment, a volatile memory comprises: a first plurality of row lines; a second plurality of column lines; and an array of vertical thyristors having anodes coupled to one of the row and column lines and having cathodes coupled to the other of the row and column lines.

In an embodiment, a method of making a volatile memory array having row lines, column lines, and an array of vertical thyristors having anodes coupled to one of the row and column lines and having cathodes coupled to the other of the row and column lines, the method comprises: introducing opposite conductivity type dopant into a first conductivity type semiconductor substrate to thereby provide a buried layer providing a cathode for each of the vertical thyristors; forming a first conductivity type epitaxial layer on the buried layer; removing all of the epitaxial layer and the buried layer to expose portions of the substrate from a first plurality of parallel regions extending in a first direction of the memory array to thereby form a first plurality of deep trenches; filling the first plurality of deep trenches with insulating material; removing all of the epitaxial layer to expose portions of the buried layer from a second plurality of parallel regions extending in a second direction of the memory array to thereby form a second plurality of shallow trenches; filling the second plurality of shallow trenches with insulating material; introducing opposite conductivity type dopant into an upper portion of the epitaxial layer to form upper opposite conductivity type regions separated from the buried layer by a lower portion of the epitaxial layer; and introducing first conductivity type dopant into a top portion of the upper opposite conductivity type regions to form an anode for each of the vertical thyristors.

In an embodiment, a method of making a volatile memory array having row lines, column lines, and an array of vertical thyristors having anodes coupled to one of the row and column lines and having cathodes coupled to the other of the row and column lines, the method comprises: introducing opposite conductivity type dopant into a first conductivity type semiconductor substrate to thereby provide a buried layer providing a cathode for each of the vertical thyristors; forming a first epitaxial layer of first conductivity type on the buried layer; forming a second epitaxial layer of opposite conductivity type on the first epitaxial layer; removing all of the first and second epitaxial layers and the buried layer to expose portions of the substrate from a first plurality of parallel regions extending in a first direction of the memory array to thereby form a first plurality of deep trenches; filling the first plurality of deep trenches with insulating material; removing all of the of the first and second epitaxial layers to expose portions of the buried layer from a second plurality of parallel regions extending in a second direction of the memory array to thereby form a second plurality of shallow trenches; filling the second plurality of shallow trenches with insulating material; and introducing first conductivity type dopant into a top portion of the second epitaxial layer to form an anode for each of the vertical thyristors.

In an embodiment, voltage does not change between read/write/retention.

In an embodiment, voltage may be regulated by a temperature-compensated source.

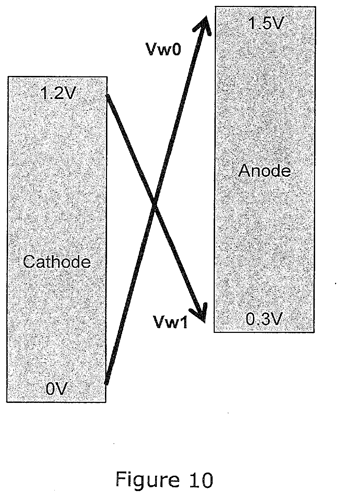

In an embodiment, a result may include lower AC voltages. In an embodiment, as shown in Figure 10, a result may include elimination of 2.5 volt transistor.

In an embodiment, operating condition may include 1.2 volt transistor.

In an embodiment, as shown in Figure 10, a result may include elimination of RMW. This may be because half-disturb risk in cross-point is gone due to lower operational voltage.

In an embodiment, operating window may be improved from -40 degrees C to 125 degrees C.

In an embodiment, macro area efficiency is increased.

In an embodiment, capacitive coupling cell-to-cell is reduced.

In an embodiment, as illustrated in Figure 6, bit lines (M1 layer) are connected to P+ anodes and word lines (M2 layer) are connected to N+ cathodes. In an embodiment, the sidewall gates (that assist writing) may include tungsten, such as having an appropriate conductivity. In an embodiment, a vertical PFET stretches from P+ region of thyristor down to PW region. In an embodiment, the edge overlap provides a shield to capacitance. In an embodiment, buried tungsten bridges between bNW are formed, such as with ohmic contact, and near, or at, bottom of STI trenches. In an embodiment, M2 strap between drops.

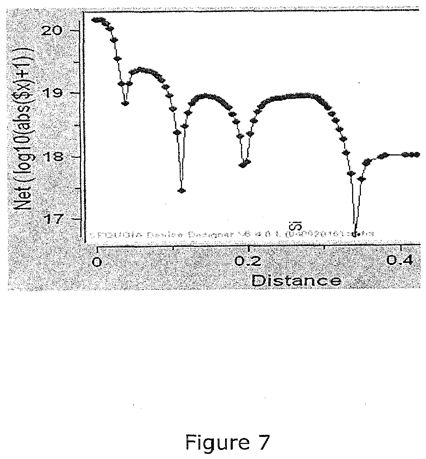

In an embodiment, as illustrated in Figure 7, doping levels of the thyristor are shown. In an embodiment, some peaks may include a shoulder.

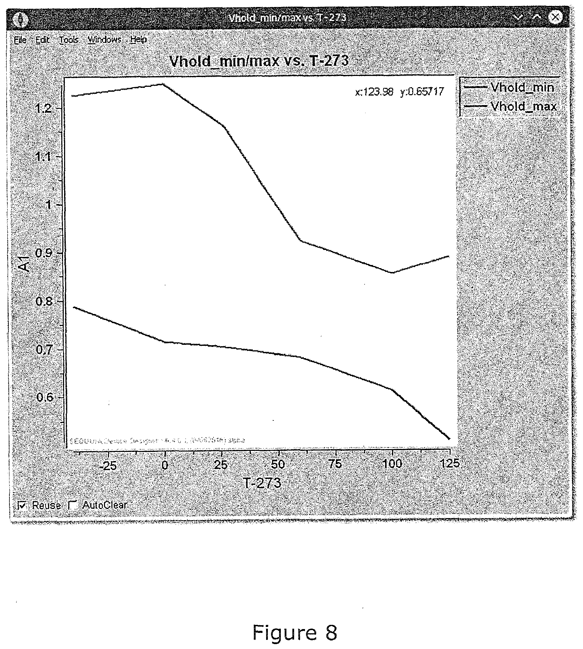

In an embodiment, as illustrated in Figure 8, DC voltages (retention and disturb) show a large window.

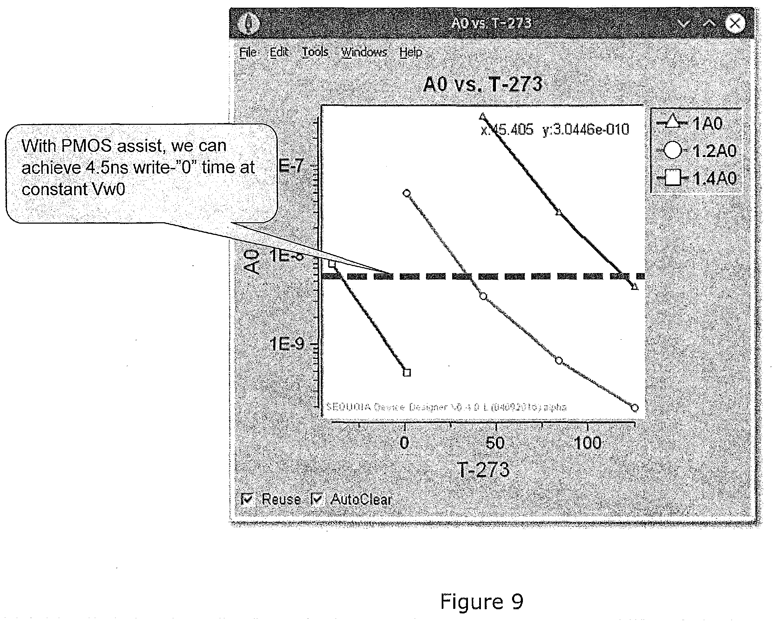

In an embodiment, as illustrated in figure 9, AC trigger time is kept substantially constant across temperature.

One potential issue with respect to using an array of thyristors as memory cells is the requirement for higher row currents during access operations to read the memory cells. We use the word 'row' as synonymous with anode, and 'column' as synonymous with cathode. Word line and bit line could also be used. To reduce the need for higher row currents we use a technique we refer to as rolling the word line.

The above data encoding techniques, or other similar approaches, are useful where the array standby current is to be maintained at a relatively constant level, and used for a current source controlled standby operation. Conventional logic circuitry can be used to detect the number and position of the ones, perform the desired inversions (or not) and add the parity bits to the stored data.

Data stored in the thyristor memory array are maintained in standby by supplying a hold voltage or current so that refresh is not needed. Under these standby conditions, all memory cells holding '0' data conduct a very low, but finite current. Due to the exponential relationship between hold current and hold voltage, a current source may be used to keep cells alive in standby. We describe a technique of maintaining data retention at a low standby current using a constant current source to bias the array to the optimum holding voltage.

Under bias schemes described above, all memory cells holding '0' data conduct a very low but finite current in order to maintain the array data without the need for refresh. An alternative approach is to adjust the current provided to an even lower value that is not sufficient to maintain the data integrity indefinitely, but which is sufficient to maintain it for a minimum "retention" period - e.g. 1msec. This approach allows a significant reduction in the standby current. To maintain the integrity of the data indefinitely, however, a background refresh operation is performed on a sector by sector basis where the set holding current for a sector is increased to a higher value for a short period to re-establish the cell levels to a better value, but then reduced back to the normal standby current. This allows all the cells in the sector to be refreshed simultaneously, rather than on a row-by-row basis as is currently done with conventional DRAMs. Further, the refresh does not interfere with normal read/write operations, making the refresh operation externally invisible.

This description of the invention has been presented for the purposes of illustration and description. It is not intended to be exhaustive or to limit the invention to the precise form described, and many modifications and variations are possible in light of the teaching above. The embodiments were chosen and described in order to best explain the principles of the invention and its practical applications. This description will enable others skilled in the art to best utilize and practice the invention in various embodiments and with various modifications as are suited to a particular use. The scope of the invention is defined by the following claims.

### EMBODIMENTS

Although the present invention is defined in the attached claims, it should be understood that the present invention can also (alternatively) be defined in accordance with the following embodiments:
1. A volatile memory comprising:
   a first plurality of row lines;
   a second plurality of column lines; and
   an array of vertical thyristors having anodes coupled to one of the row and column lines and having cathodes coupled to the other of the row and column lines.
2. A volatile memory as in embodiment 1 wherein each vertical thyristor comprises:
   a substrate of first conductivity type;
   a buried layer of opposite conductivity type extending in a first direction to provide a cathode of the thyristor and a first column line;
   a first layer of first conductivity type disposed on the buried layer to provide a first conductivity type base of the thyristor;
   a second layer of opposite conductivity type disposed on the first layer to provide an opposite conductivity type base of the thyristor;
   an upper layer of first conductivity type to provide an anode of the thyristor; and
   a conductive layer coupled to the anode of the thyristor and extending in a second direction orthogonal to the first direction to provide a first row line.
3. A volatile memory as in embodiment 2 further comprising:
   a deep region of insulating material extending through the buried layer to the substrate in the first direction to separate columns of thyristors from each other; and
   a shallow region of insulating material extending to the buried layer to separate rows of thyristors from each other.
4. A volatile memory as in embodiment 3 wherein:
   the substrate comprises silicon;
   each of the first layer, the second layer, and the upper layer comprise portions of an epitaxial silicon layer; and
   each of the deep region and the shallow region comprise silicon dioxide.
5. A volatile memory as in embodiment 4 wherein:
   the first conductivity type is P; and
   the opposite conductivity type is N.
6. A volatile memory as in embodiment 1 further comprising an NMOS transistor coupled to the thyristor.
7. A volatile memory as in embodiment 6 wherein:
   each thyristor comprises a PNP transistor having an emitter, a base, and a collector, and an NPN transistor having an emitter, a base, and a collector;
   the PNP emitter is coupled to the row line, the PNP base is coupled to the NPN collector, the PNP collector is coupled to the NPN base, and the NPN collector is coupled to the column line;
   the NMOS transistor has one electrode provided by the NPN collector, another electrode provided by the NPN emitter, and a gate coupled to connect the NPN collector to the NPN emitter when the gate is on; and
   the memory array includes gate lines coupled to the gates of a plurality of NMOS transistor gates.
8. A volatile memory as in embodiment 7 wherein the gate lines extend parallel to the column lines.
9. A volatile memory as in embodiment 1 further comprising an PMOS transistor coupled to the thyristor.
10. A volatile memory as in embodiment 9 wherein:
   each thyristor comprises a PNP transistor having an emitter, a base, and a collector, and an NPN transistor having an emitter, a base, and a collector;
   the PNP emitter is coupled to the row line, the PNP base is coupled to the NPN collector, the PNP collector is coupled to the NPN base, and the NPN collector is coupled to the column line;
   the PMOS transistor has one electrode provided by the PNP collector, another electrode provided by the PNP emitter, and a gate coupled to connect the PNP collector to the PNP emitter when the gate is on; and
   the memory array includes gate lines coupled to the gates of a plurality of PMOS transistor gates.
11. A volatile memory as in embodiment 7 wherein the gate lines extend parallel to the column lines.
12. A method of making a volatile memory array having row lines, column lines, and an array of vertical thyristors having anodes coupled to one of the row and column lines and having cathodes coupled to the other of the row and column lines, the method comprising:
   introducing opposite conductivity type dopant into a first conductivity type semiconductor substrate to thereby provide a buried layer providing a cathode for each of the vertical thyristors;
   forming a first conductivity type epitaxial layer on the buried layer;
   removing all of the epitaxial layer and the buried layer to expose portions of the substrate from a first plurality of parallel regions extending in a first direction of the memory array to thereby form a first plurality of deep trenches;
   filling the first plurality of deep trenches with insulating material;
   removing all of the epitaxial layer to expose portions of the buried layer from a second plurality of parallel regions extending in a second direction of the memory array to thereby form a second plurality of shallow trenches;
   filling the second plurality of shallow trenches with insulating material;
   introducing opposite conductivity type dopant into an upper portion of the epitaxial layer to form upper opposite conductivity type regions separated from the buried layer by a lower portion of the epitaxial layer; and
   introducing first conductivity type dopant into a top portion of the upper opposite conductivity type regions to form an anode for each of the vertical thyristors.
13. A method as in embodiment 11 further comprising a step of providing an electrical connection to the anode.
14. A method as in embodiment 12 wherein the step of providing an electrical connection comprises:
   introducing a refractory metal into the anode; and
   annealing the anode to thereby form a metal silicide layer.
15. A method as in embodiment 11 further comprising:
   before the step of introducing first conductivity type dopant into a top portion of the upper opposite conductivity type regions, a step of forming a further epitaxial layer on an upper surface of the epitaxial layer; and
   later providing electrical connections to the further epitaxial layer to provide connections to the anodes of the thyristors.
16. A method of making a volatile memory array having row lines, column lines, and an array of vertical thyristors having anodes coupled to one of the row and column lines and having cathodes coupled to the other of the row and column lines, the method comprising:
   introducing opposite conductivity type dopant into a first conductivity type semiconductor substrate to thereby provide a buried layer providing a cathode for each of the vertical thyristors;
   forming a first epitaxial layer of first conductivity type on the buried layer;
   forming a second epitaxial layer of opposite conductivity type on the first epitaxial layer;
   removing all of the first and second epitaxial layers and the buried layer to expose portions of the substrate from a first plurality of parallel regions extending in a first direction of the memory array to thereby form a first plurality of deep trenches;
   filling the first plurality of deep trenches with insulating material;
   removing all of the of the first and second epitaxial layers to expose portions of the buried layer from a second plurality of parallel regions extending in a second direction of the memory array to thereby form a second plurality of shallow trenches;
   filling the second plurality of shallow trenches with insulating material; and
   introducing first conductivity type dopant into a top portion of the second epitaxial layer to form an anode for each of the vertical thyristors.
17. A method as in embodiment 15 further comprising a step of providing an electrical connection to the anode.
18. A method as in embodiment 16 wherein the step of providing an electrical connection comprises:
   introducing a refractory metal into the anode; and
   annealing the anode to thereby form a metal silicide layer.
19. A method as in embodiment 15 further comprising:
   before the step of introducing first conductivity type dopant into a top portion of the upper opposite conductivity type regions, a step of forming a further epitaxial layer on an upper surface of the second epitaxial layer; and
   later providing electrical connections to the further epitaxial layer to provide connections to the anodes of the thyristors.

## Claims

1. A volatile memory comprising:
a first plurality of row lines;
a second plurality of column lines; and
an array of vertical thyristors having anodes coupled to one of the row and column lines and having cathodes coupled to the other of the row and column lines.

2. A volatile memory as in claim 1 wherein each vertical thyristor comprises:
a substrate of first conductivity type;
a buried layer of opposite conductivity type extending in a first direction to provide a cathode of the thyristor and a first column line;
a first layer of first conductivity type disposed on the buried layer to provide a first conductivity type base of the thyristor;
a second layer of opposite conductivity type disposed on the first layer to provide an opposite conductivity type base of the thyristor;
an upper layer of first conductivity type to provide an anode of the thyristor; and
a conductive layer coupled to the anode of the thyristor and extending in a second direction orthogonal to the first direction to provide a first row line.

3. A volatile memory as in claim 2 further comprising:
a deep region of insulating material extending through the buried layer to the substrate in the first direction to separate columns of thyristors from each other; and
a shallow region of insulating material extending to the buried layer to separate rows of thyristors from each other.

4. A volatile memory as in claim 3 wherein:
the substrate comprises silicon;
each of the first layer, the second layer, and the upper layer comprise portions of an epitaxial silicon layer; and
each of the deep region and the shallow region comprise silicon dioxide, and
optionally wherein the first conductivity type is P and the opposite conductivity type is N.

5. A volatile memory as in claim 1 further comprising an NMOS transistor coupled to the thyristor.

6. A volatile memory as in claim 5 wherein:
each thyristor comprises a PNP transistor having an emitter, a base, and a collector, and an NPN transistor having an emitter, a base, and a collector;
the PNP emitter is coupled to the row line, the PNP base is coupled to the NPN collector, the PNP collector is coupled to the NPN base, and the NPN collector is coupled to the column line;
the NMOS transistor has one electrode provided by the NPN collector, another electrode provided by the NPN emitter, and a gate coupled to connect the NPN collector to the NPN emitter when the gate is on; and
the memory array includes gate lines coupled to the gates of a plurality of NMOS transistor gates, and
optionally wherein either:
a) the gate lines extend parallel to the column lines, or
b) the gate lines extend parallel to the column lines.

7. A volatile memory as in claim 1 further comprising an PMOS transistor coupled to the thyristor.

8. A volatile memory as in claim 7 wherein:
each thyristor comprises a PNP transistor having an emitter, a base, and a collector, and an NPN transistor having an emitter, a base, and a collector;
the PNP emitter is coupled to the row line, the PNP base is coupled to the NPN collector, the PNP collector is coupled to the NPN base, and the NPN collector is coupled to the column line;
the PMOS transistor has one electrode provided by the PNP collector, another electrode provided by the PNP emitter, and a gate coupled to connect the PNP collector to the PNP emitter when the gate is on; and
the memory array includes gate lines coupled to the gates of a plurality of PMOS transistor gates.

9. A method of making a volatile memory array having row lines, column lines, and an array of vertical thyristors having anodes coupled to one of the row and column lines and having cathodes coupled to the other of the row and column lines, the method comprising:
introducing opposite conductivity type dopant into a first conductivity type
semiconductor substrate to thereby provide a buried layer providing a cathode for each of the vertical thyristors;
forming a first conductivity type epitaxial layer on the buried layer;
removing all of the epitaxial layer and the buried layer to expose portions of the substrate from a first plurality of parallel regions extending in a first direction of the memory array to thereby form a first plurality of deep trenches;
filling the first plurality of deep trenches with insulating material;
removing all of the epitaxial layer to expose portions of the buried layer from a second plurality of parallel regions extending in a second direction of the memory array to thereby form a second plurality of shallow trenches;
filling the second plurality of shallow trenches with insulating material;
introducing opposite conductivity type dopant into an upper portion of the epitaxial layer to form upper opposite conductivity type regions separated from the buried layer by a lower portion of the epitaxial layer; and
introducing first conductivity type dopant into a top portion of the upper opposite conductivity type regions to form an anode for each of the vertical thyristors.

10. A method as in claim 9 further comprising a step of providing an electrical connection to the anode, and optionally wherein the step of providing the electrical connection comprises introducing a refractory metal into the anode and annealing the anode to thereby form a metal silicide layer.

11. A method as in claim 9 further comprising:
before the step of introducing first conductivity type dopant into a top portion of the upper opposite conductivity type regions, a step of forming a further epitaxial layer on an upper surface of the epitaxial layer; and
later providing electrical connections to the further epitaxial layer to provide connections to the anodes of the thyristors.

12. A method of making a volatile memory array having row lines, column lines, and an array of vertical thyristors having anodes coupled to one of the row and column lines and having cathodes coupled to the other of the row and column lines, the method comprising:
introducing opposite conductivity type dopant into a first conductivity type semiconductor substrate to thereby provide a buried layer providing a cathode for each of the vertical thyristors;
forming a first epitaxial layer of first conductivity type on the buried layer;
forming a second epitaxial layer of opposite conductivity type on the first epitaxial layer;
removing all of the first and second epitaxial layers and the buried layer to expose portions of the substrate from a first plurality of parallel regions extending in a first direction of the memory array to thereby form a first plurality of deep trenches;
filling the first plurality of deep trenches with insulating material;
removing all of the of the first and second epitaxial layers to expose portions of the buried layer from a second plurality of parallel regions extending in a second direction of the memory array to thereby form a second plurality of shallow trenches;
filling the second plurality of shallow trenches with insulating material; and
introducing first conductivity type dopant into a top portion of the second epitaxial layer to form an anode for each of the vertical thyristors.

13. A method as in claim 12 further comprising a step of providing an electrical connection to the anode.

14. A method as in claim 13 wherein the step of providing the electrical connection comprises:
introducing a refractory metal into the anode; and
annealing the anode to thereby form a metal silicide layer.

15. A method as in claim 12 further comprising:
before the step of introducing first conductivity type dopant into a top portion of the upper opposite conductivity type regions, a step of forming a further epitaxial layer on an upper surface of the second epitaxial layer; and
later providing electrical connections to the further epitaxial layer to provide connections to the anodes of the thyristors.
